(19) Europäisches Patentamt
European Patent Office
Office européen des brevets

(11) **EP 3 009 851 B1**

(12) **FASCICULE DE BREVET EUROPEEN**

(45) Date de publication et mention de la délivrance du brevet:
**04.09.2024 Bulletin 2024/36**

(21) Numéro de dépôt: **15185369.4**

(22) Date de dépôt: **15.09.2015**

(51) Classification Internationale des Brevets (IPC):
***G01R 22/06*** *(2006.01)*

(52) Classification Coopérative des Brevets (CPC):
**G01R 22/066**

(54) **COMPTEUR PERMETTANT DE DÉTECTER UNE FRAUDE PAR BY-PASS**

ZÄHLER ZUM AUFDECKEN VON BETRUG DURCH BYPASS

COUNTER FOR DETECTING FRAUD BY BYPASS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.10.2014 FR 1459785**

(43) Date de publication de la demande:
**20.04.2016 Bulletin 2016/16**

(73) Titulaire: **SAGEMCOM ENERGY & TELECOM SAS 92270 Bois-Colombes (FR)**

(72) Inventeurs:
• **TEBOULLE, Henri**
**92270 Bois-Colombes (FR)**
• **GINESTET, Patrick**
**92270 Bois-Colombes (FR)**
• **HERGAULT, Stéphane**
**92270 Bois-Colombes (FR)**

(74) Mandataire: **Cabinet Boettcher et al**
**5, rue de Vienne**
**75008 Paris (FR)**

(56) Documents cités:
**FR-A1- 2 996 310    US-A1- 2009 261 805**

## Description

L'invention concerne un compteur d'énergie électrique permettant de détecter une tentative de fraude par by-pass ainsi qu'un procédé de détection d'une telle tentative de fraude.

ARRIERE PLAN DE L'INVENTION

Un compteur d'énergie électrique d'une installation électrique comporte très classiquement un capteur de courant (shunt, transformateur, etc.) destiné à mesurer un courant de phase consommé par l'installation électrique et circulant sur un conducteur de phase.

Une méthode de fraude connue consiste à relier à l'extérieur du compteur un point du conducteur de phase situé en amont du compteur à un point du conducteur de phase situé en aval du compteur.

On forme de la sorte une branche de dérivation externe dans laquelle circule au moins une partie du courant consommé par l'installation électrique. Ce type de fraude est usuellement désigné par le terme « by-pass ».

Un utilisateur fraudeur peut donc ainsi constituer une installation électrique principale alimentée via le compteur et dont la consommation électrique est normalement mesurée par le compteur, et une installation électrique additionnelle connectée à la branche de dérivation et dont la consommation électrique n'est pas pris en compte par la mesure réalisée par le compteur.

Dans le cas d'un compteur moderne, le relevé de la consommation est effectué à distance et ne nécessite plus l'intervention sur le compteur d'un agent releveur de compteur. Il est donc fondamental pour le distributeur d'énergie électrique qu'une telle tentative de fraude puisse être détectée sans intervention sur le compteur.

Pour détecter une telle tentative de fraude, une première solution consiste à mesurer un courant de neutre circulant sur un conducteur de neutre, à comparer le courant de neutre et le courant de phase (ou la valeur efficace de la somme des trois courants de phase dans le cas d'un compteur triphasé), et à détecter une tentative de fraude lorsque le rapport entre le courant de phase et le courant de neutre est supérieur à un seuil prédéterminé, ou inférieur à un autre seuil prédéterminé. Cette première solution ne permet cependant pas de détecter une tentative de fraude lorsque l'utilisateur fraudeur différencie, d'une part, le retour de neutre de l'installation électrique additionnelle, qu'il connecte en amont du compteur, et, d'autre part, le retour de neutre de l'installation électrique principale, qu'il connecte au compteur en aval du compteur.

Une deuxième solution, notamment décrite dans le document FR 2 983 301, consiste à connecter dans le compteur un élément de transformation entre le conducteur de phase et le conducteur de neutre, à générer un premier signal de type courant porteur en ligne au niveau d'une entrée de l'élément de transformation, à acquérir et analyser un deuxième signal de type courant porteur en ligne au niveau d'une sortie de l'élément de transformation, et à détecter la présence d'une branche de dérivation externe en fonction du résultat de cette analyse. Cette deuxième solution est non seulement coûteuse et encombrante, mais elle est aussi incompatible avec des exigences particulièrement sévères de robustesse à des courants injectés qui peuvent être spécifiées pour certains compteurs. Ces exigences peuvent ainsi consister, pour tester un organe de coupure du compteur (ou « breaker ») destiné à sélectivement connecter et déconnecter l'installation électrique du réseau de distribution, à soumettre l'organe de coupure à des injections de courants pouvant atteindre 5000 ampères pendant 10 millisecondes.

Les documents FR2996310A1 et US2009/261805A1 sont des documents de l'art antérieur qui divulguent des compteurs d'énergie électrique.

OBJET DE L'INVENTION

L'invention a pour objet un compteur électrique permettant de détecter une fraude par by-pass de manière fiable, peu onéreuse et robuste.

RESUME DE L'INVENTION

En vue de la réalisation de ce but, on propose un compteur d'énergie électrique pour mesurer un courant circulant sur un conducteur entre un réseau de distribution et une installation électrique tel que décrit dans la revendication 1, le compteur comprenant un premier capteur de courant monté sur le conducteur et un élément résistif monté sur le conducteur en série avec le premier capteur de courant, le compteur comprenant en outre des moyens de détection d'une tentative de by-pass frauduleux du compteur. Selon l'invention, les moyens de détection comportent un organe de coupure de test monté en parallèle de l'élément résistif.

Pour détecter la tentative de by-pass, les moyens de détection du compteur de l'invention sont donc connectés à un unique conducteur. La méthode de détection ne consiste donc pas à comparer un courant circulant sur un conducteur de phase et un courant circulant sur un conducteur de neutre. Les moyens de détection du compteur de l'invention ne peuvent donc pas être contournés comme ceux de la première solution évoquée plus tôt, et améliorent ainsi la fiabilité de la détection.

Les moyens de détection comprennent uniquement des composants simples, peu onéreux et robustes (en l'occurrence l'organe de coupure), et sont donc capables de résister aux forts courants auxquels est soumis le compteur au cours de sa qualification.

On propose de plus un procédé de détection d'une tentative de by-pass frauduleux d'un compteur tel que précédemment décrit, le procédé comportant les étapes :

- de mesurer avec le premier capteur de courant un premier courant circulant sur le conducteur alors que le premier courant est stable et alors que l'organe de coupure de test est ouvert ;
- de fermer l'organe de coupure de test ;
- de mesurer avec le premier capteur de courant un deuxième courant circulant sur le conducteur alors que l'organe de coupure de test est fermé ;
- de détecter une tentative de fraude lorsque le rapport entre le premier courant et le deuxième courant est supérieur à un premier seuil prédéterminé, ou inférieur à un deuxième seuil prédéterminé.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés, parmi lesquels :

- la figure 1 représente un schéma électrique d'un compteur de l'invention selon un premier mode de de réalisation ;
- la figure 2 représente un schéma électrique d'un compteur de l'invention selon un deuxième mode de de réalisation ;
- la figure 3 représente un schéma électrique d'un compteur de l'invention selon un troisième mode de de réalisation ;
- la figure 4 représente un schéma électrique d'un compteur de l'invention selon un quatrième mode de de réalisation.

DESCRIPTION DETAILLEE DE L'INVENTION

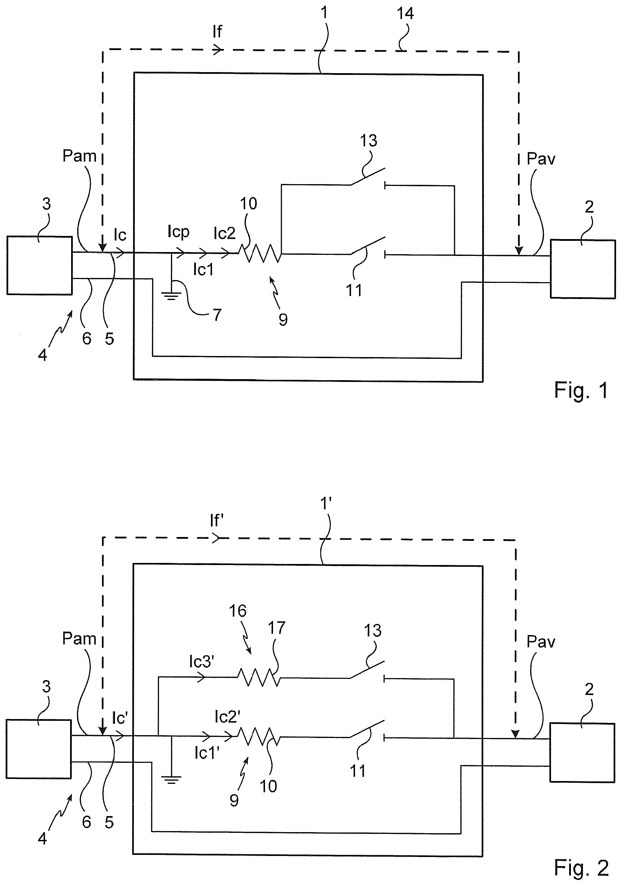

En référence à la figure 1, un compteur d'énergie électrique de l'invention 1 selon un premier mode de réalisation est un compteur monophasé destiné à mesurer une énergie électrique consommée par une installation électrique 2 située en aval du compteur 1 et fournie par un réseau de distribution 3 situé en amont du compteur 1.

L'énergie électrique est transmise à l'installation électrique 2 par une ligne électrique 4 comprenant un conducteur de phase 5 et un conducteur de neutre 6 auxquels est raccordé le compteur 1. Une masse électrique 7 du compteur 1 est reliée au conducteur de phase 5 du compteur 1.

La mesure de l'énergie électrique consiste notamment à mesurer un courant consommé Ic circulant sur le conducteur de phase 5. Pour mesurer ce courant consommé Ic, le compteur 1 comporte un premier capteur de courant 9 qui est monté sur le conducteur de phase 5 et qui comporte un premier shunt 10.

Le compteur 1 comporte de plus un organe de coupure de connexion 11 monté sur le conducteur de phase 5 en série avec le premier capteur de courant 9. L'organe de coupure de connexion 11 permet de sélectivement connecter et déconnecter, à distance, l'installation électrique 2 du réseau de distribution 3.

L'organe de coupure de connexion 11 est utilisé pour protéger l'installation électrique 2 en s'ouvrant lorsqu'il est soumis à une surtension accidentelle provenant du réseau de distribution 3, et en se refermant suite à cette surtension accidentelle sur commande d'un opérateur du distributeur d'énergie électrique. L'organe de coupure de connexion 11 est aussi utilisé pour couper ou rétablir à distance l'alimentation de l'installation électrique 2 en cas par exemple de résiliation de l'abonnement de l'utilisateur de l'installation électrique 2 ou de non-paiement de l'énergie électrique consommée, sans qu'il soit nécessaire d'envoyer du personnel sur place.

Le compteur 1 de l'invention comprend en outre des moyens de détection d'une tentative de by-pass frauduleux du compteur 1 qui comportent un organe de coupure de test 13 monté en parallèle de l'organe de coupure de connexion 11. L'organe de coupure de test 13 permet donc de détecter un by-pass frauduleux qui est symbolisé sur la figure 1 par la ligne en pointillés représentant un court-circuit réalisé à l'aide d'un fil 14 reliant à l'extérieur du compteur 1 un point amont Pam du conducteur de phase 5 situé en amont du compteur à un point aval Pav du conducteur de phase 5 situé en aval du compteur 1.

Pour détecter une tentative de by-pass, on met en oeuvre le procédé de détection d'une tentative de by-pass de l'invention, qui consiste tout d'abord à mesurer avec le premier capteur de courant 9 la valeur d'un premier courant Ic1 circulant sur le conducteur de phase 5 alors que le premier courant Ic1 est stable et alors que l'organe de coupure de connexion 11 est fermé et que l'organe de coupure de test 13 est ouvert.

On ferme alors l'organe de coupure de test 13, et on mesure avec le premier capteur de courant 9 la valeur d'un deuxième courant Ic2 circulant sur le conducteur de phase 5 tout en gardant l'organe de coupure de connexion 11 et l'organe de coupure de test 13 fermés.

En fonctionnement normal, à partir du point amont Pam, le conducteur de phase 5 qui s'étend dans le compteur 1 forme la seule branche disponible sur laquelle peut circuler le courant consommé Ic, et donc le courant mesuré par le premier capteur de courant 9 ne varie pas en fonction de l'état ouvert ou fermé de l'organe de coupure de test 13. Le premier courant Ic1 et le deuxième courant Ic2 sont donc égaux.

En cas de tentative de by-pass, à partir du point amont Pam, deux branches sont disponibles pour le courant consommé Ic : le fil 14 et le conducteur de phase 5 qui s'étend dans le compteur 1. La répartition entre un courant If circulant sur le fil 14 et le courant Icp circulant sur le conducteur de phase 5 est telle que :

$$Ic = Icp + If,$$

avec

$$Icp=Rf/(Rf+Rcp).Ic$$

et

$$If= Rcp/(Rf+Rcp).Ic,$$

où Rf est la résistance du fil 14 et Rcp est la résistance du conducteur de phase 5 s'étendant dans le compteur 1 entre le point amont et le point aval, du premier shunt 10, et de l'organe de coupure de connexion 11 en parallèle avec l'organe de coupure de test 13.

Or, cette résistance Rcp varie selon que l'organe de coupure de test 13 est ouvert ou fermé. Ainsi, en cas de tentative de by-pass, la valeur de Icp lorsque l'organe de coupure de test 13 est ouvert (ou valeur du premier courant Ic1) diffère de la valeur de Icp lorsque l'organe de coupure de test 13 est fermé (ou valeur du deuxième courant Ic2).

On détecte ainsi une tentative de fraude lorsque le rapport entre la valeur du premier courant Ic1 et la valeur du deuxième courant Ic2 est supérieur à un premier seuil prédéterminé, ou inférieur à un deuxième seuil prédéterminé.

On illustre cette description en produisant à titre indicatif les valeurs numériques qui suivent.

Le fil 14 est typiquement un fil de cuivre d'une longueur L de 16 cm, d'une section S de 6 mm2 (calibre d'un fil électrique 32 ampères) et d'une résistivité $\rho$ = 18 n$\Omega$.m. Le fil 14 présente une résistance Rf d'environ de 0.5 mO calculée à partir de ces valeurs numériques en utilisant la formule Rf = $\rho$.L/S. Pour tenir compte des moyens de connexion utilisés pour connecter le fil 14 au point amont Pam et au point aval Pav, on considérera que la résistance Rf du fil 14 est de l'ordre de 1 m$\Omega$.

La résistance de l'organe de coupure de connexion 11, des moyens de connexion associés et du premier shunt 10 est d'environ 2 mS2 lorsque l'organe de coupure de connexion 11 est fermé, et presque infinie lorsqu'il est ouvert. La résistance de l'organe de coupure de test 13 et des moyens de connexion associés est d'environ 2 m$\Omega$ lorsque l'organe de coupure de test 13 est fermé, et presque infinie lorsqu'il est ouvert (la résistance du premier shunt 10 est en effet de l'ordre de 0,1 m$\Omega$, soit très faible devant celle des organes de coupure 11, 13). La résistance Rcp est donc égale à environ 2 mS2 lorsque l'organe de coupure de connexion 11 est fermé et l'organe de coupure de test est ouvert 13, et à 1 mS2 lorsque l'organe de coupure de connexion 11 et l'organe de coupure de test 13 sont fermés.

Le premier courant Ic1 est donc tel que :

$$Ic1 = 1/3.Ic ,$$

et le deuxième courant Ic2 est donc tel que :

$$Ic2 = 1/2.Ic.$$

On choisit, pour garder une marge suffisante, de détecter une tentative de by-pass lorsque Ic2/Ic1>1,2 c'est-à-dire lorsque la différence entre la valeur du premier courant Ic1 est supérieure de 20% à la valeur du deuxième courant Ic2.

Dans un deuxième mode de réalisation, visible sur la figure 2, les moyens de détection du compteur d'énergie électrique de l'invention 1' comportent un deuxième capteur de courant 16 monté en série avec l'organe de coupure de test 13, le deuxième capteur de courant 16 et l'organe de coupure de test 13 étant montés en parallèle du premier capteur de courant 9 et l'organe de coupure de connexion 11. Le deuxième capteur de courant 16 comporte un deuxième shunt 17.

Pour détecter une tentative de by-pass, on met en oeuvre le procédé de détection d'une tentative de by-pass de l'invention selon un deuxième mode de réalisation, qui consiste tout d'abord à mesurer avec le premier capteur de courant 9 un premier courant Ic1' circulant sur le conducteur de phase 5 alors que le premier courant Ic1' est stable et alors que l'organe de coupure de connexion 11 est fermé et que l'organe de coupure de test 13 est ouvert. On ferme alors l'organe de coupure de test 13, et on mesure avec le premier capteur de courant 9 un deuxième courant Ic2' circulant sur le conducteur de phase 5 alors que l'organe de coupure de connexion 11 est fermé et que l'organe de coupure de test 13 est fermé, puis on mesure avec le deuxième capteur de courant 16 un troisième courant Ic3' circulant dans l'organe de coupure de test 13 alors que l'organe de coupure de connexion 11 est fermé et que l'organe de coupure de test 13 est fermé.

En fonctionnement normal, à partir du point amont Pam, le conducteur de phase 5 qui s'étend dans le compteur 1 et l'organe de coupure de test 13 associé au deuxième capteur de courant 16 forment les deux seules branches disponibles sur lesquelles peut circuler le courant consommé Ic'. Ainsi, le premier courant Ic1' mesuré par le premier capteur 9 lorsque l'organe de coupure de connexion 11 est fermé et l'organe de coupure de test 13 est ouvert doit être égal à la valeur efficace de la somme du deuxième courant Ic2' mesuré par le premier capteur de courant 9 lorsque l'organe de coupure de test 13 est fermé et du troisième courant Ic3' mesuré par le deuxième capteur de courant 16 lorsque l'organe de coupure de test 13 est fermé.

En cas de tentative de by-pass, à partir du point amont Pam, trois branches sont disponibles pour le courant consommé Ic' : le fil 14, le conducteur de phase 5, et la branche formée par l'organe de coupure de test 13 associé au deuxième capteur de courant 16. En suivant un raisonnement semblable à celui proposé plus tôt, on comprend que la répartition entre les courants circulant dans ces trois branches dépend de la résistance associée à chaque branche et donc que cette répartition est différente selon que l'organe de coupure de test 13 est ouvert ou fermé.

En réalisant un calcul semblable, on obtient que le premier courant est tel que :

$$Ic1'=1/3.Ic',$$

et que

$$Ic2'+Ic3'=1/2.Ic'.$$

On choisit à nouveau, pour garder une marge suffisante, de détecter une tentative de by-pass lorsque (Ic2'+Ic3')/Ic1'>1,2 c'est-à-dire lorsque la valeur efficace de la somme de la valeur du deuxième courant Ic2' et du troisième courant Ic3' est supérieure de 20% à la valeur du premier courant Ic1'.

On note que l'utilisation de deux organes de coupure 11, 13 permet d'utiliser des organes de coupure moins volumineux : le volume ajouté des deux organes de coupure est inférieur au volume d'un seul organe de coupure. On note aussi que cette solution est avantageuse thermiquement, car l'échauffement ajouté des deux organes de coupure est inférieur à celui d'un seul organe de coupure.

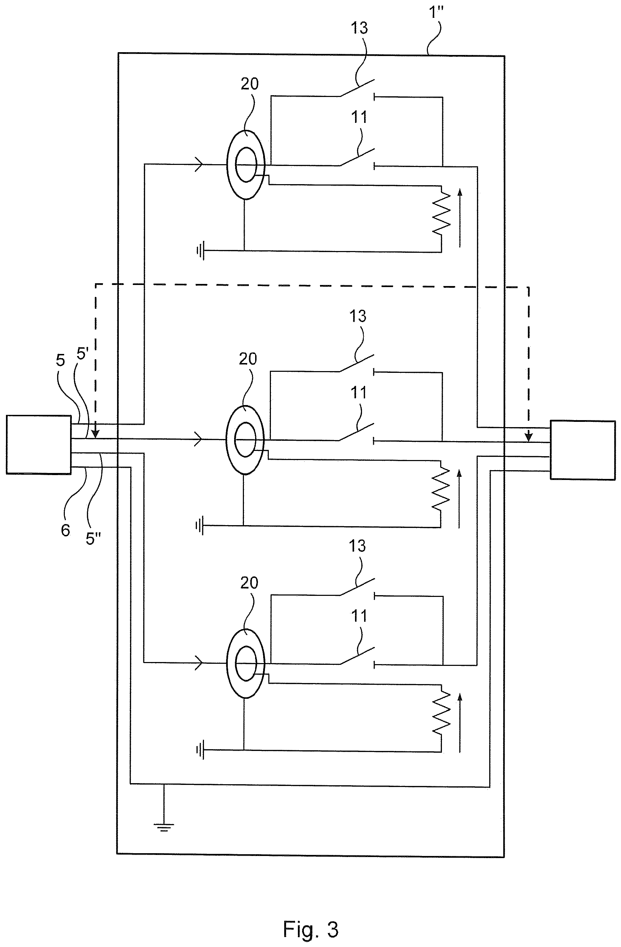

Dans un troisième mode de réalisation, visible sur la figure 3, le compteur d'énergie électrique de l'invention 1" est un compteur triphasé raccordé à une ligne électrique comprenant trois conducteurs de phase 5, 5', 5" et un conducteur de neutre 6, ledit compteur 1" étant référencé au neutre. Les moyens de détection comportent ici, pour chaque conducteur de phase 5, 5',5'', des moyens de détection semblables aux moyens de détection du compteur 1 selon le premier mode de réalisation, si ce n'est que le shunt de chaque conducteur est remplacé par un capteur de courant comportant un transformateur de courant 20. Le procédé de détection s'applique de la même manière que pour le compteur 1 selon le premier mode de réalisation, si ce n'est que l'on compare cette fois la valeur efficace de la somme des courants des trois phases, avec les organes de coupure de test 16 ouverts puis fermés. Sur la figure 3, la tentative de by-pass est effectuée sur le deuxième conducteur de phase.

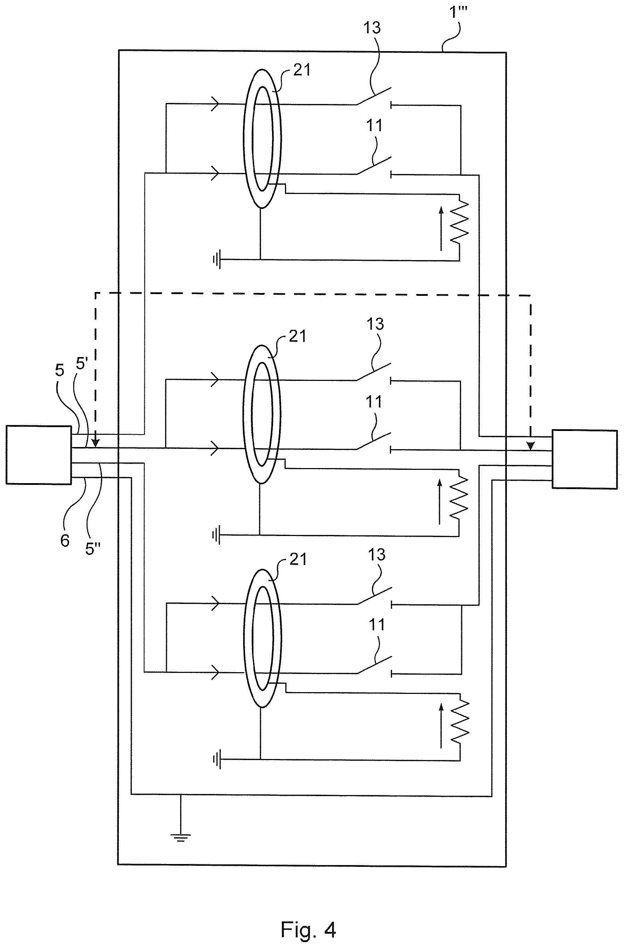

Dans un quatrième mode de réalisation, visible sur la figure 4, le compteur d'énergie électrique de l'invention 1‴ est un compteur triphasé raccordé à une ligne électrique comprenant trois conducteurs de phase et un conducteur de neutre, ledit compteur étant référencé au neutre. Les moyens de détection comportent ici, pour chaque conducteur de phase, des moyens de détection semblables aux moyens de détection du compteur selon le deuxième mode de réalisation, si ce n'est que le premier shunt du premier capteur de courant et le deuxième shunt du deuxième capteur de courant sont remplacés par un unique capteur de courant comportant un transformateur de courant 21. Chaque transformateur de courant s'étend autour du conducteur de phase associé et de la branche comportant l'organe de coupure de test 13, de sorte que le courant mesuré par le transformateur de courant 21 est égal à la somme du courant circulant dans le conducteur de phase et du courant circulant dans l'organe de coupure de test 13 lorsqu'il est fermé. Le procédé de détection s'applique de la même manière que pour le compteur selon le deuxième mode de réalisation, si ce n'est que l'on compare cette fois la valeur efficace de la somme des courants des trois phases, avec les deuxièmes organes de coupure ouverts puis fermés. Sur la figure 4, la tentative de by-pass est effectuée sur le deuxième conducteur de phase.

Dans chacun des compteurs de l'invention 1, 1', 1", 1‴, l'information de détection de la tentative de by-pass est remontée au distributeur d'énergie électrique par exemple via une transmission par courants porteurs en ligne à un concentrateur de données ou à un système informatique. La détection de la tentative de by-pass peut aussi conduire à allumer et à maintenir allumée une diode électroluminescente située dans le compteur.

L'invention n'est pas limitée aux modes de mise en oeuvre particuliers qui viennent d'être décrits, mais, bien au contraire, couvre toute variante entrant dans le cadre de l'invention telle que définie par les revendications.

On a indiqué dans tout le texte que des « courants » sont mesurés par les capteurs de courant ; par « courants », on entend préférablement la valeur de courant efficace de ces courants.

Certains compteurs électriques ne comportent pas d'organe de coupure tel que l'organe de coupure de connexion, utilisé pour sélectivement connecter et déconnecter l'installation électrique du réseau de distribution. Or, l'organe de coupure de connexion est principalement utilisé dans les moyens de détection du compteur de l'invention en tant qu'élément résistif lorsqu'il est fermé. On peut donc le remplacer par un autre type d'élément résistif, typiquement par une résistance ayant une valeur de résistance similaire à celle d'un organe de coupure fermé (entre 1 m$\Omega$ et 2 m$\Omega$). Ceci ne s'applique bien sûr pas à l'organe de coupure de test.

Bien que l'on ait indiqué que les capteurs de courant des compteurs monophasé comprennent un shunt et ceux des compteurs triphasés comprennent un transformateur, il est possible d'utiliser des transformateurs dans les compteurs monophasés et des shunts dans les compteurs triphasés.

## Revendications

**1.** Compteur d'énergie électrique pour mesurer un courant (Ic) circulant sur un conducteur (5, 5', 5") entre un réseau de distribution (3) et une installation électrique (2), le compteur comprenant un premier capteur de courant (9) monté sur le conducteur et un élément résistif (11) monté sur le conducteur en série avec le premier capteur de courant (9), le compteur comprenant en outre des moyens de détection d'une tentative de by-pass frauduleux du compteur,

les moyens de détection comportant un organe de coupure de test (13) monté en parallèle de l'élément résistif (11), **caractérisé en ce que** l'élément résistif (11) comporte également un organe de coupure de connexion (11) pour sélectivement connecter et déconnecter l'installation électrique (2) du réseau de distribution (3).

2. Compteur selon la revendication 1, dans lequel les moyens de détection comportent un deuxième capteur de courant (16) monté en série avec l'organe de coupure de test (13), le deuxième capteur de courant et l'organe de coupure de test étant montés en parallèle du premier capteur de courant et de l'élément résistif.

3. Compteur selon l'une des revendications précédentes, le compteur étant un compteur monophasé et le conducteur étant un conducteur de phase (5, 5', 5").

4. Compteur selon l'une des revendications 1 ou 2, le compteur étant un compteur triphasé dans lequel chaque conducteur de phase (5, 5', 5") comporte un premier capteur de courant (9), un élément résistif (11) et est équipé des moyens de détection.

5. Compteur selon l'une des revendications 2 à 4, dans lequel le premier capteur de courant et/ou le deuxième capteur de courant comportent chacun un shunt de mesure (10, 17) .

6. Compteur selon l'une des revendications 2 à 4, dans lequel le premier capteur de courant et/ou le deuxième capteur de courant comporte chacun un transformateur de courant (20, 21).

7. Procédé de détection d'une tentative de by-pass frauduleux d'un compteur selon la revendication 1, le procédé comportant les étapes :

- de mesurer avec le premier capteur de courant (9) un premier courant (Ic1) circulant sur le conducteur alors que le premier courant est stable et que l'organe de coupure de test (13) est ouvert ;
- de fermer l'organe de coupure de test (13) ;
- de mesurer avec le premier capteur de courant (9) un deuxième courant (Ic2) circulant sur le conducteur alors que l'organe de coupure de test est fermé ;
- de détecter une tentative de fraude lorsque le rapport entre le premier courant et le deuxième courant est supérieur à un premier seuil prédéterminé, ou inférieur à un deuxième seuil prédéterminé.

8. Procédé de détection d'une tentative de by-pass frauduleux d'un compteur selon la revendication 2, le procédé comportant les étapes :

- de mesurer avec le premier capteur de courant un premier courant circulant (Ic1') sur le conducteur alors que le premier courant (Ic1') est stable et alors que l'organe de coupure de test (13) est ouvert ;
- de fermer l'organe de coupure de test ;
- de mesurer avec le premier capteur de courant (9) un deuxième courant (Ic2') circulant sur le conducteur alors que l'organe de coupure de test est fermé ;
- de mesurer avec le deuxième capteur de courant un troisième courant circulant dans l'organe de coupure de test alors que l'organe de coupure de test est fermé ;
- de détecter une tentative de fraude lorsque le rapport entre le premier courant et la valeur efficace de la somme du deuxième courant et du troisième courant est supérieur à un troisième seuil prédéterminé, ou inférieur à un quatrième seuil prédéterminé.

**Patentansprüche**

1. Elektroenergiezähler zum Messen eines Stroms (Ic), der in einem Leiter (5, 5', 5") zwischen einem Verteilungsnetz (3) und einer elektrischen Anlage (2) fließt, wobei der Zähler einen an den Leiter angeschlossenen ersten Stromsensor (9) und ein auf dem Leiter mit dem ersten Stromsensor (9) in Reihe geschaltetes Widerstandselement (11) umfasst, wobei der Zähler ferner Detektionsmittel zum Erkennen eines betrügerischen Bypass-Versuchs an dem Zähler umfasst,

wobei die Detektionsmittel ein Testabschaltglied (13) enthält, das mit dem Widerstandselement (11) parallelgeschaltet ist, **dadurch gekennzeichnet, dass** das Widerstandselement (11) ebenfalls ein Verbindungsunterbrechungsglied (11) enthält, um die elektrische Anlage (2) selektiv mit dem Verteilungsnetz (3) zu verbinden und von diesem zu trennen.

2. Zähler nach Anspruch 1, wobei die Detektionsmittel einen zweiten Stromsensor (16) enthalten, der mit dem Testabschaltglied (13) in Reihe geschaltet ist, wobei der zweite Stromsensor und das Testabschaltglied mit dem ersten Stromsensor und dem Widerstandselement parallelgeschaltet sind.

3. Zähler nach einem der vorhergehenden Ansprüche, wobei es sich bei dem Zähler um einen Einphasenzähler und bei dem Leiter um einen Phasenleiter (5, 5', 5") handelt.

4. Zähler nach einem der Ansprüche 1 oder 2, wobei es sich bei dem Zähler um einen Drehstromzähler handelt, bei welchem jeder Phasenleiter (5, 5', 5'') einen ersten Stromsensor (9) und ein Widerstandselement (11) enthält und mit den Detektionsmitteln ausgestattet ist.

5. Zähler nach einem der Ansprüche 2 bis 4, wobei der erste Stromsensor und/oder der zweite Stromsensor jeweils einen Messshunt (10, 17) enthalten.

6. Zähler nach einem der Ansprüche 2 bis 4, wobei der erste Stromsensor und/oder der zweite Stromsensor jeweils einen Stromwandler (20, 21) enthalten.

7. Detektionsverfahren zum Erkennen eines betrügerischen Bypass-Versuchs an einem Zähler nach Anspruch 1, wobei das Verfahren die Schritte enthält, dass:

   - mithilfe des ersten Stromsensors (9) ein erster Strom (Ic1) gemessen wird, der über den Leiter fließt, während der erste Strom stabil ist und das Testabschaltglied (13) offen ist;
   - das Testabschaltglied (13) geschlossen wird;
   - mithilfe des ersten Stromsensors (9) ein zweiter Strom (Ic2) gemessen wird, der über den Leiter fließt, während das Testabschaltglied geschlossen ist;
   - ein Betrugsversuch erkannt wird, wenn das Verhältnis zwischen dem ersten Strom und dem zweiten Strom größer als ein vorbestimmter erster Schwellenwert oder kleiner als ein vorbestimmter zweiter Schwellenwert ist.

8. Detektionsverfahren zum Erkennen eines betrügerischen Bypass-Versuchs an einem Zähler nach Anspruch 2, wobei das Verfahren die Schritte enthält, dass:

   - mithilfe des ersten Stromsensors ein erster Strom (Ic1') gemessen wird, der über den Leiter fließt, während der erste Strom (Ic1') stabil ist und das Testabschaltglied (13) offen ist;
   - das Testabschaltglied geschlossen wird;
   - mithilfe des ersten Stromsensors (9) ein zweiter Strom (Ic2') gemessen wird, der über den Leiter fließt, während das Testabschaltglied geschlossen ist;
   - mithilfe des zweiten Stromsensors ein dritter Strom gemessen wird, der über das Testabschaltglied fließt, während das Testabschaltglied geschlossen ist;
   - ein Betrugsversuch erkannt wird, wenn das Verhältnis zwischen dem ersten Strom und dem Effektivwert der Summe aus dem zweiten Strom und dem dritter Strom größer als ein vorbestimmter dritter Schwellenwert oder kleiner als ein vorbestimmter vierter Schwellenwert ist.

**Claims**

1. Electrical energy meter for measuring a current (Ic) flowing on a conductor (5, 5', 5'') between a distribution network (3) and an electrical installation (2), the meter comprising a first current sensor (9) mounted on the conductor and a resistive element (11) mounted on the conductor in series with the first current sensor (9), the meter further comprising means for detecting an attempt to fraudulently bypass the meter,

   the detection means comprising a test cut-off member (13) mounted in parallel with the resistive element (11),
   **characterized in that** the resistive element (11) also comprises a connection cut-off element (11) for selectively connecting and disconnecting the electrical installation (2) from the distribution network (3).

2. Meter according to claim 1, wherein the detection means comprise a second current sensor (16) series-connected with the test cut-off member (13), the second current sensor and the test cut-off member being mounted in parallel with the first current sensor and the resistive element.

3. Meter according to one of the preceding claims, the meter being a single-phase meter and the conductor being a phase conductor (5, 5', 5").

4. Meter according to any one of claims 1 or 2, the meter being a three-phase meter in which each phase conductor (5, 5', 5") comprises a first current sensor (9), a resistive element (11) and is equipped with the detection means.

5. Meter according to any one of claims 2 to 4, wherein the first current sensor and/or the second current sensor each comprise a measurement shunt (10, 17).

6. Meter according to any one of claims 2 to 4, wherein the first current sensor and/or the second current sensor each comprises a current transformer (20, 21).

7. Method of detecting an attempt to fraudulently by-pass the meter according to claim 1, the method comprising the steps of:

- measuring with the first current sensor (9) a first current (Ic1) flowing on the conductor while the first current is stable and the test cut-off member (13) is open;
- closing the test cut-off member (13);
- measuring with the first current sensor (9) a second current (Ic2) flowing on the conductor while the test cut-off member is closed;
- detecting an attempted fraud when the ratio between the first current and the second current is greater than a first predetermined threshold, or less than a second predetermined threshold.

8. Method of detecting an attempt to fraudulently by-pass the meter according to claim 2, the method comprising the steps of:

- measuring with the first current sensor a first current (Ic1') flowing on the conductor while the first current (Ic1') is stable and while the test cut-off member (13) is open;
- closing the test cut-off member;
- measuring with the first current sensor (9) a second current (Ic2') flowing on the conductor while the test cut-off member is closed;
- measuring with the second current sensor a third current flowing in the test cut-off member while the test cut-off member is closed;
- detecting an attempted fraud when the ratio between the first current and the effective value of the sum of the second current and the third current is greater than a third predetermined threshold, or less than a fourth predetermined threshold.

Fig. 1

Fig. 2

Fig. 3

Fig. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2983301
- FR 2996310 A1
- US 2009261805 A1